# EUROPÄISCHE PATENTSCHRIFT

(11) **EP 0 788 197 B1**
(45) Veröffentlichungstag und Bekanntmachung des Hinweises auf die Patenterteilung: **15.05.2002**
(21) Anmeldenummer: 97100486.6
(22) Anmeldetag: 15.01.1997
(51) Int. Cl.: H01R 12/18, H01R 12/20

(54) **Baugruppenleiterplatte mit Steckverbinder**
Circuit board assembly plug connector
Plaquette à circuits ayant un connecteur à fiche

(30) Priorität: 31.01.1996 DE 29601655 U
(43) Veröffentlichungstag der Anmeldung: 06.08.1997
(73) Patentinhaber: SIEMENS AKTIENGESELLSCHAFT, 80333 München (DE)
(72) Erfinder: Zell, Karl, Dipl.-Ing., 82343 Niederpöcking (DE); Seibold, Jürgen, Dipl.-Ing., 82065 Baierbrunn (DE); Seidel, Peter, 82194 Gröbenzell (DE)

(56) Entgegenhaltungen:
- FR-A- 2 667 452
- US-A- 4 909 743
- IBM TECHNICAL DISCLOSURE BULLETIN, Bd. 31, Nr. 5, Oktober 1988, ARMONK, NY, USA, Seiten 73-74, XP000023405 "double-sided right-angle pin connector"

## Beschreibung

Die vorliegende Erfindung betrifft eine Baugruppenleiterplatte mit einem mit dieser fest verbundenen Steckverbinder.

Bisher wurden Einpreßsteckverbinder im wesentlichen nur einseitig auf einer Baugruppenleitrplatte angebracht. Da die Packungsdichte der auf der Baugruppenleiterplatte angeordneten Bauelemente immer weiter zunimmt, reicht oft die Kapazität der auf der Baugruppenleiterplatte angebrachten Steckverbinder nicht aus, um die Baugruppenleiterplatte signalmäßig und versorgungsmäßig ausreichend mit den übrigen Baugruppen eines Systems zu verbinden.

Zur Lösung dieses Problems wurde die Polzahl der verwendeten Steckverbinder erhöht. Jedoch treten Fälle auf, in denen eine derartige Maßnahme auch weiterhin nicht ausreichend ist. Aus diesem Grund wurden auf beiden Seiten einer Leiterplatte Steckverbinder in SMD-Technik angebracht (siehe zum Beispiel US-A-4 909 743). Dabei ist allerdings nachteilig, daß das Anbringen der Steckverbinder mittels dieser Technik eine Wärmebehandlung erfordert.

Aufgabe der vorliegenden Erfindung ist es, eine Baugruppenleiterplatte mit einem mit dieser fest verbundenen Steckverbinder anzugeben, welche mit einer hohen Polzahl an Steckverbindungen mit dem übrigen System verbunden werden kann, ohne daß eine nachteilige Wärmebehandlung notwendig ist.

Diese Aufgabe wird erfindungsgemäß für die eingangs genannte Baugruppenleiterplatte dadurch gelöst, daß die Leiterplatte aus zwei Multilayer besteht, die mit einer dazwischenliegenden Isolierfolie, welche zur galvanischen Trennung dient und beidseitig Klebeflächen aufweist, wobei der Anschlußbereich für die Steckverbinder vorgebohrt und entsprechend durchkontaktiert ist, und daß auf beiden Seiten der Leiterplatte Steckverbinder mit verkürzten Anschlußstiften in die Multilayer eingepreßt sind.

Bei der erfindungsgemäßen Baugruppenleiterplatte können zur Erhöhung der Polzahl für die externen Anschlüsse die Steckverbinder spiegelbildlich angeordnet werden. Da die Steckverbinder als Einpreßsteckverbinder ausgebildet sind, entfällt eine nachteilige Wärmebehandlung.

Eine zweckmäßige Ausgestaltung der erfindungsgemäßen Baugruppenleiterplatte ist dadurch gekennzeichnet, daß im Bereich der Steckverbinder zur vorgegebenen Verbindung von bestimmten Multilayer-Schichten miteinander sogenannte Umsteiger vorgesehen sind. Auf diese Weise kann eine leichte galvanische Verbindung zwischen bestimmten Multilayer-Schichten erreicht werden.

Eine andere zweckmäßige Ausgestaltung der erfindungsgemäßen Leiterplatte ist dadurch gekennzeichnet, daß sich der untere Multilayer nur im Anschlußbereich der Steckverbinder erstreckt. Bei dieser Ausführungsform ist einer der Multilayer lediglich als ein Multilayer-Segment ausgebildet, welches im Anschlußbereich des Steckverbinders über Durchkontaktierungen mit dem Haupt-Multilayer elektrisch verbunden ist. Bei dieser Ausführung kann im wesentlichen eine Multilayer-Platte eingespart werden.

Eine weitere zweckmäßige Ausgestaltung der Baugruppenleiterplatte gemäß der vorliegenden Erfindung sieht vor, daß der freie Bereich zwischen den Steckverbindern vor der Stirnseite der Leiterplatte zur Aufnahme von Codiervorrichtungen dient.

Nachstehend wird die Erfindung anhand von zwei in der Zeichnung dargestellten Ausführungsbeispielen näher erläutert.

Es zeigen
Figur 1 einen Schnitt durch eine Baugruppenleiterplatte, welche aus zwei Multilayern besteht und mit zwei Steckverbindern bestückt ist, und
Figur 2 einen Schnitt durch eine Baugruppenleiterplatte, welche aus einem Multilayer und einem Multilayer-Segment besteht und mit zwei Steckverbindern bestückt ist.

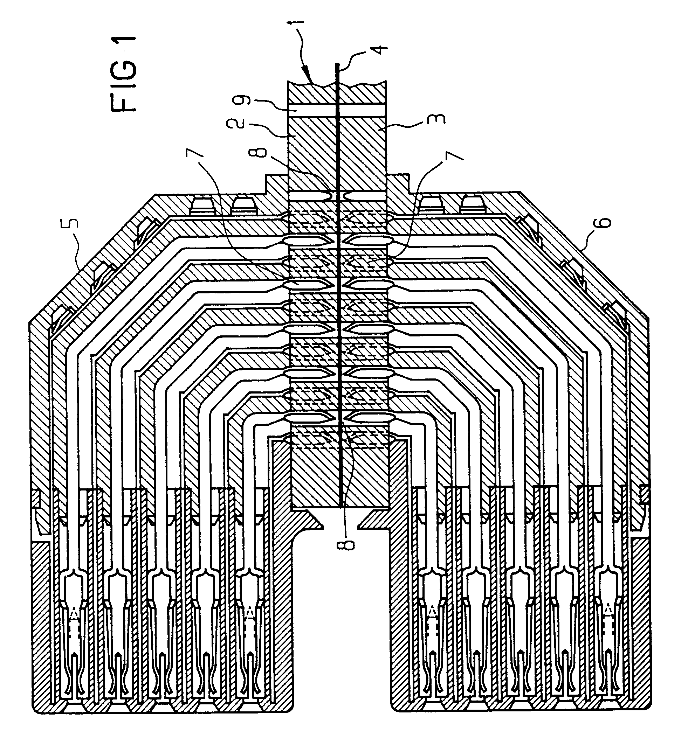

Figur 1 zeigt eine Baugruppenleiterplatte 1, welche aus einem oberen Multilayer 2 und einem unteren Multilayer 3 besteht. Die beiden Multilayer 2 und 3 sind durch eine Isolierfolie 4, welche auf beiden Seiten Klebeflächen aufweist, getrennt. Dabei sind die beiden Multilayer 2 und 3 und die Isolierfolie 4, auch Prepreg genannt, zusammengepreßt, so daß sie eine Einheit bilden. Im Anschlußbereich der Steckverbinder 5 und 6 ist die Baugruppenleiterplatte 1 mit Bohrungen 8 für Umsteiger-,Einpreß- und Befestigungslöcher usw. versehen.

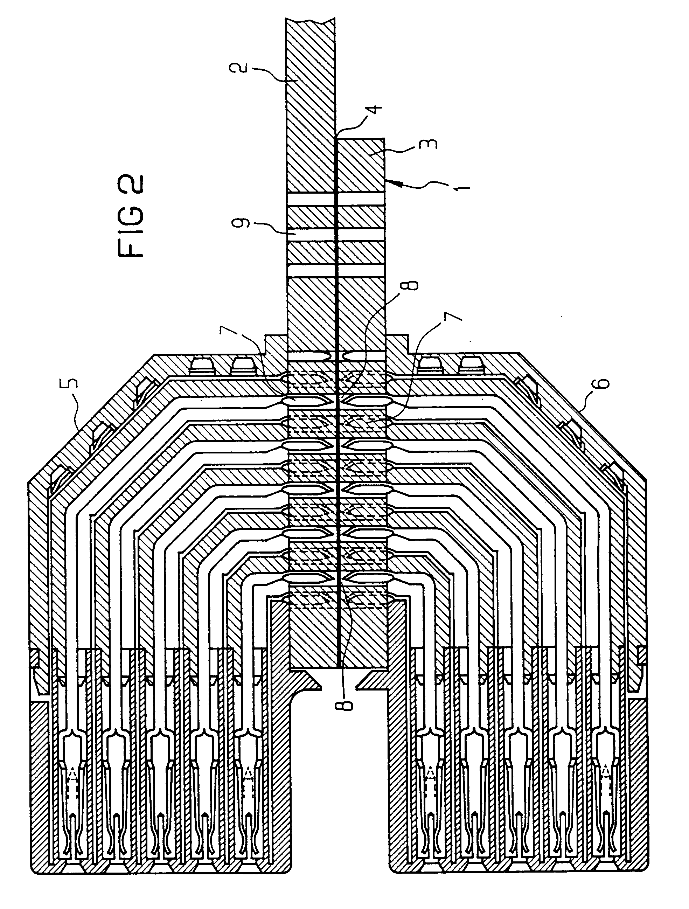

Figur 2 zeigt im wesentlichen den gleichen Aufbau wie Figur 1, jedoch handelt es sich hier bei dem unteren Multilayer 3 lediglich um ein Multilayer-Segment, welches im wesentlichen im Bereich der Steckverbinder 5 und 6 ausgebildet ist.

In den Figuren sind Steckverbinder mit geschirmten Einzelkontakten dargestellt, jedoch ist die vorliegende Erfindung nicht nur auf derartige Steckverbinder beschränkt, sondern ist allgemein für alle Einpreßsteckverbinder anwendbar.

Bisher erfolgte das Anbringen von Einpreßsteckverbindern im wesentlichen nur einseitig auf einer Baugruppenleiterplatte, deren Dicke von 1,6 mm in der Regel nicht überschritten wurde. Die Einpreßzone von Haltezapfen und Kontakten konnte daher auch länger als die Durchkontaktierung der Baugruppenleiterplatte ausgeführt sein.

Bei Steckverbindern mit geschirmten Einzelkontakten muß aufgrund der Anordnung der Signalstifte und der Schirmungsstifte im versetzten Raster die Baugruppenleiterplatte ein Multilayer sein. Da bereits 10-lagige Multilayer in einer Dicke von 1,6 mm fertigbar sind, können auch noch höherlagige Multilayer mit dem erforderlichen Wellenstand mit einer in diesem Fall maximalen Dicke von 2,4 mm realisiert werden.

Das wesentliche dieser Erfindung liegt darin, daß zwei dieser 2,4 mm starken Multilayer - getrennt durch ein Prepreg - zusammen verpreßt sind, wobei der Anschlußbereich für die Steckverbinder entsprechend gebohrt und durchkontaktiert ist. Einer der Multilayer kann auch nur ein Multilayer-Segment sein, das innerhalb des Anschlußbereichs der Steckverbinder über Durchkontaktierungen mit dem Haupt-Multilayer elektrisch verbunden ist.

Die Anschlußlöcher für die beidseitig angeordneten Steckverbinder auf einer z. B. 5 mm dicken verpreßten Leiterplatte 1 können auch als Sacklöcher gebohrt und metallisiert hergestellt werden.

In diese Sacklöcher werden dann die Steckverbinder mit rundum geschirmten Einzelkontakten eingepreßt. Hierbei ist die Einpreßzone der Kontakte sowie der Schirmbleche mit Einlaufspitzen ca. 2 mm lang, d. h. kleiner als die Hälfte der Dicke eines Multilayers. Bei dickeren Multilayern kann die Einpreßzone entsprechend angepaßt (länger) sein.

Der zwischen den beiden Steckverbindern 5 und 6 verbleibende Raum kann z. B. für Codierelemente verwendet werden.

Zusammenfassend kann festgestellt werden, daß die auf ein Minimum verkürzten Einpreßzonen bzw. die auf ein Minimum verkürzten Haltezapfen zusammen mit den im Anschlußbereich der Steckverbinder halbierten und gegeneinander isolierten Durchkontaktierungen eines Multilayers spiegelbildliche Steckverbinder-Anordnung ohne Pinverlust und ohne Einbuße an Schirmungsqualität ermöglichen.

## Patentansprüche

1. Baugruppenleiterplatte mit einem mit dieser fest verbundenen Steckverbinder,
**dadurch gekennzeichnet,**
**daß** die Leiterplatte (1) aus zwei Multilayern (2, 3) besteht, die mit einer dazwischenliegenden Isolierfolie (4), welche zur galvanischen Trennung dient und beidseitig Klebeflächen aufweist, miteinander verpreßt sind, wobei der Anschlußbereich für die Steckverbinder vorgebohrt und entsprechend durchkontaktiert ist, und
**daß** auf beiden Seiten der Leiterplatte (1) Steckverbinder (5, 6) mit verkürzten Anschlußstiften (7) in die Multilayer (2, 3) eingepreßt sind.

2. Baugruppenleiterplatte nach Anspruch 1,
**dadurch gekennzeichnet,**
**daß** im Bereich der Steckverbinder (5, 6) zur vorgegebenen Verbindung bestimmter Multilayer-Schichten miteinander sogenannte Umsteiger vorgesehen sind.

3. Baugruppenleiterplatte nach Anspruch 1 oder 2,
**dadurch gekennzeichnet,**
**daß** sich der untere Multilayer (3) nur im Anschlußbereich der Steckverbinder (5, 6) erstreckt.

4. Baugruppenleiterplatte nach einem der vorhergehenden Ansprüche,
**dadurch gekennzeichnet,**
**daß** der freie Bereich zwischen den Steckverbindern (5, 6) vor der Stirnseite der Leiterplatte (1) zur Aufnahme von Codiervorrichtungen dient.

## Claims

1. Component-carrying printed-circuit board with a plug-in connector firmly connected to it, **characterized in that** the printed-circuit board (1) comprises two multi-layer structures (2, 3), which are pressed together with insulating film (4) lying in between, which serves for electrical isolation and has adhesive surfaces on both sides, the terminal region for the plug-in connectors being pre-drilled and correspondingly plated-through, and **in that** plug-in connectors (5, 6) with shortened terminal pins (7) are pressed into the multi-layer structures (2, 3) on both sides of the printed-circuit board (1).

2. Component-carrying printed-circuit board according to Claim 1, **characterized in that** interconnecting devices are provided in the region of the plug-in connectors (5, 6) for the predetermined connection of certain layers of the multi-layer structures to one another.

3. Component-carrying printed-circuit board according to Claim 1 or 2, **characterized in that** the lower multi-layer structure (3) extends only in the terminal region of the plug-in connectors (5, 6).

4. Component-carrying printed-circuit board according to one of the preceding claims, **characterized in that** the free region between the plug-in connectors (5, 6) in front of the end face of the printed-circuit board (1) serves for receiving coding devices.

## Revendications

1. Plaquette à circuits ayant un connecteur à fiche raccordé de manière fixe à celle-ci,
**caractérisée en ce que** la plaquette à circuits (1) est constituée de deux multicouches (2, 3) pressées ensemble avec une feuille isolante (4) intermédiaire servant à l'isolation galvanique et présentant des surfaces adhésives des deux côtés, la partie de raccordement du connecteur étant pré-percée et les trous métallisés de manière correspondante, et
**en ce que**, des deux côtés de la plaquette à circuits (1), des connecteurs (5, 6) à broches de raccordement (7) raccourcies sont pressés dans les multicouches (2, 3).

2. Plaquette à circuits selon la revendication 1,
**caractérisée en ce que** desdits cavaliers sont prévus dans la partie des connecteurs (5, 6) pour le raccordement prédéfini de certaines couches de multicouches.

3. Plaquette à circuits selon la revendication 1 ou 2,
**caractérisée en ce que** la multicouche inférieure (3) s'étend seulement dans la partie de raccordement des connecteurs (5, 6).

4. Plaquette à circuits selon l'une des revendications précédentes,
**caractérisée en ce que** la partie libre entre les connecteurs (5, 6) devant le côté frontal de la plaquette à circuits (1) sert au logement de dispositifs de codage.
